**Europäisches Patentamt**

**European Patent Office**

**Office européen des brevets**

(19)

(11) Veröffentlichungsnummer : **0 078 075**
**B1**

# EUROPÄISCHE PATENTSCHRIFT

(12)

(45) Veröffentlichungstag der Patentschrift :
**12.02.86**

(21) Anmeldenummer : **82201277.9**

(22) Anmeldetag : **14.10.82**

(51) Int. Cl.⁴ : **H 01 L 23/48**, H 01 L 23/14,
H 01 L 23/36

(54) **Elektrischer Kontakt für Silizium-Halbleiter.**

(30) Priorität : **22.10.81 CH 6743/81**

(43) Veröffentlichungstag der Anmeldung :
**04.05.83 Patentblatt 83/18**

(45) Bekanntmachung des Hinweises auf die Patenterteilung : **12.02.86 Patentblatt 86/07**

(84) Benannte Vertragsstaaten :
**CH DE FR GB LI SE**

(56) Entgegenhaltungen :
**EP-A- 0 016 306**
**GB-A- 2 027 988**

(73) Patentinhaber : **BBC Aktiengesellschaft Brown,
Boveri & Cie.
Haselstrasse
CH-5401 Baden (CH)**

(72) Erfinder : **Gobrecht, Jens, Dr.
Birchhofstrasse 6 .
CH-5412 Gebenstorf (CH)**
Erfinder : **Schüler, Claus Cristian, Dr.
Gemeindestrasse 4
CH-8967 Widen (CH)**

## Beschreibung

Die Erfindung bezieht sich auf einen elektrischen Kontakt für Silizium-Halbleiter nach dem Oberbegriff des Anspruchs 1.

Ein solcher Kontakt ist bekannt aus dem Artikel von J. C. Driscoll et. al. in Proc. of Int. Microelectronics, Symp. of Oct. 11-13, 1976, Vancouver, Canada. Der dort beschriebene elektrische Kontakt besteht aus einer Kupferschicht und einer Oxidkeramik, welche entweder BeO oder $Al_2O_3$ ist. Die Kupferschicht ist durch ein $Cu-Cu_2O$-Eutektikum mit der Keramik verbunden. Die andere Seite der Keramik ist ebenfalls durch ein $Cu-Cu_2O$-Eutektikum mit einer Kühlplatte aus Kupfer verbunden. Die Kupferschicht ist auf der anderen Seite stoffschlüssig mit einem Silizium-Halbleiter verbunden. Auf der anderen Seite des Halbleiters sind Druckkontakte aus Kupfer angeordnet. Ein Rahmen aus Aluminium ist auf die Kühlplatte geschraubt, um auf die Druckkontakte genügend Druck auszuüben.

Der bekannte Kontakt hat den Nachteil, dass wegen der unterschiedlichen Wärmeausdehnungskoeffizienten von Silizium, Kupfer und Keramik, keine lateral beliebig grossen Silizium-Halbleiter mit derartigen Kontakten versehen werden können. Die mechanischen Spannungen, welche durch die unterschiedlichen Wärmeausdehnungen entstehen, sind dann so hoch, dass entweder die Bruchfestigkeit des Siliziums überschritten wird, oder die Grenzflächenverbindung als Folge der zyklischen thermischen Ermüdung versagt. Ein anderer Nachteil ist, dass der gegenüberliegende Kontakt aus diesen Gründen als Druckkontakt ausgeführt sein muss.

Die Erfindung stellt sich deshalb die Aufgabe, einen elektrischen Kontakt für Silizium-Halbleiter derart zu verbessern, dass der Kontakt mit der ganzen Anschlussfläche des Silizium-Halbleiters stoffschlüssig verbunden werden kann, wobei der Silizium-Halbleiter lateral beliebig gross sein kann.

Diese Aufgabe wird bei einem elektrischen Kontakt der eingangs genannten Art erfindungsgemäss durch die Merkmale des kennzeichnenden Teils des Anspruchs 1 gelöst.

Ein wichtiger Vorteil der Erfindung ist, dass die Wärmeausdehnung des Aufbaus überwiegend von der Keramik bestimmt wird. Weil der Wärmeausdehnungskoeffizient der Keramik dem des Siliziums angepasst ist, können nunmehr auch auf grosse Flächen des Silizium-Halbleiters elektrische Kontakte stoffschlüssig aufgebracht werden. Es können jetzt auch auf beiden Seiten des Silizium-Halbleiters elektrische Kontakte stoffschlüssig aufgebracht werden. Die bisher notwendigen, aufwendigen Einspannvorrichtungen sind damit nicht mehr erforderlich. Von ganz besonderer Bedeutung ist es, dass die stoffschlüssig aufgebrachten, erfindungsgemässen Kontakte auch grösste thermische Dauer- und Wechselbelastungen des Ealbleiterelementes schadlos überstehen.

Weitere Merkmale und Vorteile der Erfindung ergeben sich aus den anhand von Zeichnungen erläuterten Beispielen.

Dabei zeigt :

Figur 1 ein elektronisches Bauelement bestehend aus einem Silizium-Halbleiter mit beidseitigen elektrischen Kontakten, welches durch eine Kühlflüssigkeit gekühlt wird, und

Figur 2 ein Modul von mehreren Silizium-Halbleitern mit beidseitigen elektrischen Kontakten, welche stoffschlüssig mit einem metallischen Kühlkörper und einem metallischen Kühlrohr verbunden sind.

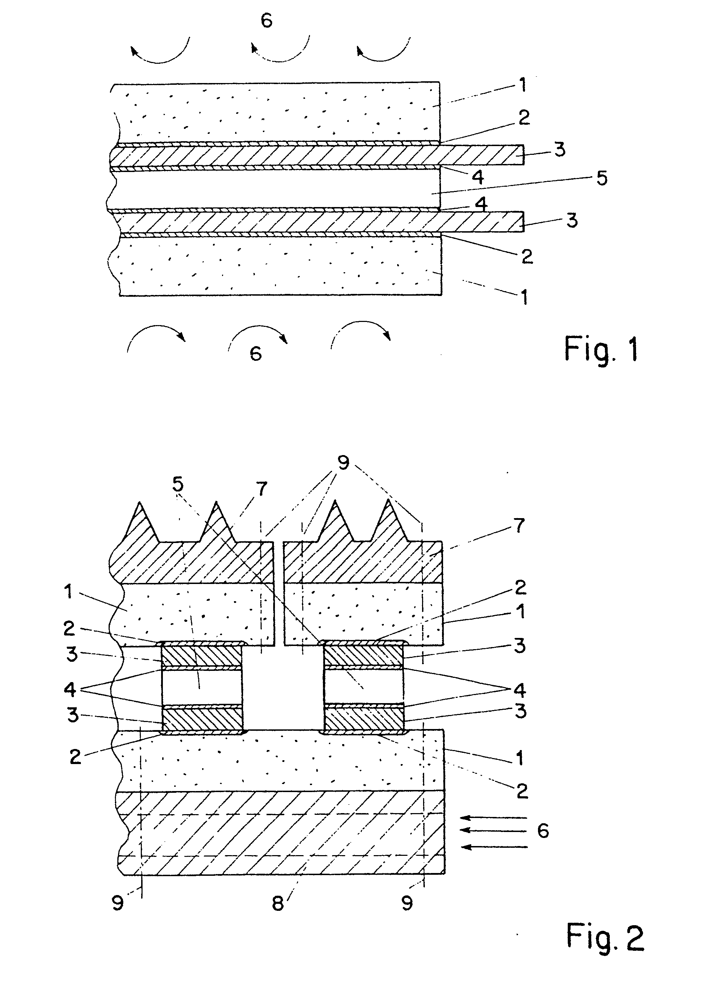

Fig. 1 zeigt einen Silizium-Halbleiter 5 mit beidseitigen elektrischen Kontakten, welche aus einer Keramik 1, einem Eutektikum 2 und einer Metallschicht 3 bestehen. Durch das Lot 4, z. B. Aluminium, ist die Metallschicht 3 mit dem Silizium-Halbleiter 5 verbunden. Das Bauelement wird mit der Kühlflüssigkeit 6 gekühlt.

Fig. 2 zeigt ein Modul von mehreren Silizium-Halbleitern 5 mit beidseitigen elektrischen Kontakten, welche aus einer Oxidkeramik 1, einem Eutektikum 2 und einer Metallschicht 3 bestehen. Durch das Lot 4 sind die Metallschichten 3 mit den Silizium-Halbleitern 5 verbunden. Der metallische Kühlkörper 7 und das metallische Kühlrohr 8 sind durch Schrauben 9 mit der Keramik 1 verbunden. Durch das metallische Kühlrohr 8 fliesst eine Kühlflüssigkeit 6.

Der lineare Wärmeausdehnungskoeffizient des Aufbaus, welche aus der Keramik 1 und der Metallschicht 3 besteht, weicht höchstens um 3 × $10^{-6}$/K von dem des Siliziums ab, welcher 2,5 × $10^{-6}$/K beträgt. Dieser Unterschied gewährleistet eine hohe Planität der Verbindung zwischen dem Silizium-Halbleiter 5 und dem elektrischen Kontakt. Bei Hochleistungsbetrieb können Temperaturen von 500 K in dem 300 μm dicken Silizium-Halbleiter 5 entstehen. Die Wärmeleitfähigkeit des Aufbaus, welche grösser ist als 3 W/m · K, gewährleistet dann einen einwandfreien Betrieb.

Besonders vorteilhaft ist ein Aufbau, welche aus einer Keramik 1 von 50 bis 3 000 μm Dicke und einer Metallschicht 3 von 20 bis 3 000 μm Dicke besteht, und bei der das Dickenverhältnis zwischen der Keramik 1 und der Metallschicht 3 grösser als 1 ist. Dadurch ist eine hervorragende Planität des elektrischen Kontaktes gewährleistet. Dieser Vorteil ist besonders günstig bei Metallen mit einer Fliessspanung von höchstens 50 MPa für 2 % Verformung. Der lineare Wärmeausdehnungskoeffizient des Aufbaus wird dann in besonders hohem Masse von der Keramik 1 bestimmt. Um andersseits die elektrischen Verluste gering zu halten, besitzt die Metallschicht 3 vorzugsweise einen spezifischen Widerstand kleiner als 20 × $10^{-9}$ Ωm.

Geglühtes Kupfer entspricht diesen Bedingungen, mit einer Fliessspannung von 30 − 40 MPa und einem spezifischen Widerstand von 17 × $10^{-9}$ Ωm, besonders gut. Die Verwendung von dicken Kupferschichten garantiert auch eine bessere Wärmeleitfähigkeit des Aufbaus, so dass derartig ausgeführte elektrische Kontakte grössere Leistungen des Silizium-Halbleiters 5 ermöglichen.

Die Keramik 1 ist mit Vorteil eine etwa 500 $\mu$m dicke Mullitscheibe. Die chemische Formel für Mullit ist $3Al_2O_3 \cdot 2SiO_2$. Der lineare Wärmeausdehnungskoeffizient von reinem Mullit beträgt 4,5 bis 5,0 $\times$ $10^{-6}$/K, und seine Wärmeleitfähigkeit beträgt 6 W/m $\cdot$ K. Durch eine geringe Veränderung der idealen Zusammensetzung des Mullits wird der Ausdehnungskoeffizient kleiner. Das hier verwendete Mullit ist ein « Typ-O Mullit » der Firma Coors Porcelain, USA, mit einem linearen Ausdehnungskoeffizienten von 3,8 $\times$ $10^{-6}$/K und einer Wärmeleitfähigkeit von 4 W/m K. Mit besonderem Vorteil kann die Keramik 1 auch aus Zinnoxid bestehen, welches einen Ausdehnungskoeffizienten von 3,7 $\times$ $10^{-6}$/K und eine Wärmeleitfähigkeit von 26 W/m K besitzt.

Die Keramik 1 und die Metallschicht 3 sind durch ein Eutektikum 2 miteinander verbunden. Bei Mullit und Kupfer ist dies ein $Cu\text{-}Cu_2O$-Eutektikum. Solche eutektischen Verbindungen werden ausführlich beschrieben in dem Artikel von J. F. Burgess et. al. in J. Electrochem. Soc. von Mai 1975, Seiten 688 bis 690. Vorzugsweise besitzt die Keramik 1 eine Dicke von etwa 500 $\mu$m und die vorzugsweise aus Kupfer bestehende Metallschicht 3 eine Dicke von 300 $\mu$m. Dadurch werden besonders günstige Eigenschaften des Aufbaus im Sinne der Erfindung erzielt.

Um eine gute Planität auch bei dicken Metallschichten 3 (z. B. 300 $\mu$m) zu gewährleisten, werden die Metallschichten vor dem eutektischen Verbinden durch photolithographisches Aetzen mit regelmässigen Schlitzen versehen. Die aus Kupfer bestehende Metallschicht 3 wird im Hochvakuum bei 650 °C unter einem Druck von etwa $10^4$ Pa mit Aluminium als Lot 4 an den Silizium-Halbleiter 5 angelötet. Prinzipiell eignet sich aber jedes Lot, das eine ausreichende thermische Wechselfestigkeit besitzt, z. B. Pb. Das Lot 4 hat eine Dicke von etwa 10 $\mu$m.

Der Kühlkörper 7 besteht aus Aluminium und ist durch Schrauben 9 derart mit der Keramik 1 verbunden, dass der Ausdehnungskoeffizient des Kühlkörpers 7 den der Keramik 1 nicht beeinflusst. Zum Beispiel können die Durchgangsbohrungen für die Schrauben in den Kühlkörpern 7 überdimensioniert sein. Zur Verbesserung des Wärmeüberganges können zwischen den Kühlkörpern 7 und den Keramiken 1 dünne Schichten aus synthetischem Wachs vorgesehen sein. Das Kühlrohr 8 besteht aus Kupfer und ist ebenfalls durch Schrauben 9 mit der Keramik 1 verbunden.

Wenn aus schaltungstechnischen Gründen mehrere, gleichartige Silizium-Halbleiter 5 benötigt sind, ist der Aufbau als Modul, welcher in Fig. 2 gezeigt wird, besonders geeignet. Z. B. ist auf diese Art eine Brückenschaltung von Hochleistungshalbleitern ausgezeichnet herstellbar. Die (nicht-gezeichneten) elektrischen Leitungen, welche mit den Metallschichten 3 verbunden sind, werden zur oberen Seite, bzw. zur unteren Seite jedes Halbleiterelementes ausgeführt. Wegen der elektrischen Isolierung sind die Keramiken 1 und die Kühlkörper 7 einzeln auf die oberen Seiten der Siliziumhalbleiter 5 montiert.

### Patentansprüche

1. Elektrischer Kontakt für einen Silizium-Halbleiter (5), welcher aus einem Aufbau einer Keramik (1) und einer Metallschicht (3) besteht, wobei die Metallschicht (3) einen kleinen elektrischen Widerstand besitzt und auf der einen Seite durch ein Eutektikum (2) mit der Keramik (1), und auf der anderen Seite stoffschlüssig mit dem Silizium-Halbleiter (5) verbunden ist, dadurch gekennzeichnet, dass der Aufbau (1) einen linearen Wärmeausdehnungskoeffizienten besitzt, welcher im Wert höchstens um $3 \cdot 10^{-6}$/K von dem des Siliziums abweicht, und eine Wärmeleitfähigkeit besitzt, welche grösser ist als 3 W/m K, und dass die Metallschicht (3) mittels einer Lotschicht (4) mit dem Silizium-Halbleiter (5) verbunden ist.

2. Elektrischer Kontakt nach Anspruch 1, dadurch gekennzeichnet, dass die Keramik (1) eine Dicke von 50 bis 3 000 $\mu$m besitzt, und dass die Metallschicht (3) eine Dicke von 20 bis 3 000 $\mu$m besitzt, wobei das Verhältnis zwischen der Dicke der Keramik (1) und der Dicke der Metallschicht (3) grösser als 1 ist.

3. Elektrischer Kontakt nach Anspruch 2, dadurch gekennzeichnet, dass die Metallschicht (3) eine Fliessspannung von höchstens 50 MPa für 0,2 % Verformung und einen spezifischen Widerstand von höchstens $20 \cdot 10^{-9}$ $\Omega$.m aufweist.

4. Elektrischer Kontakt nach Anspruch 3, dadurch gekennzeichnet, dass die Metallschicht (3) aus Kupfer besteht.

5. Elektrischer Kontakt nach einem der Ansprüche 1 bis 4, dadurch gekennzeichnet, dass die Keramik (1) Mullit ist, welches die chemische Bezeichnung $3Al_2O_3 \cdot 2SiO_2$ besitzt.

6. Elektrischer Kontakt nach einem der Ansprüche 1 bis 4, dadurch gekennzeichnet, dass die Keramik (1) Zinnoxyd ist.

7. Elektrischer Kontakt nach einem der Ansprüche 1 bis 6, dadurch gekennzeichnet, dass die Keramik (1) eine Dicke von 500 $\mu$m, und die Metallschicht (3) eine Dicke von 300 $\mu$m aufweist.

8. Elektrischer Kontakt nach einem der Ansprüche 1 bis 7, dadurch gekennzeichnet, dass zur stoffschlüssigen Verbindung der Metallschicht (3) mit dem Silizium-Halbleiter (5) eine Aluminiumschicht (4) vorgesehen ist.

### Claims

1. Electric contact for a silicon semiconductor (5), which contact consists of an assembly of a ceramic material (1) and a metal layer (3), in which arrangement the metal layer (3) has a low electric resistance and is on one side connected by a eutectic (2) to the ceramic material (1) and on the other side joined by its material to the silicon semiconductor (5), characterised in that the assembly (1) has a linear coefficient of thermal expansion the value of which deviates by a maximum of $3 \cdot 10^{-6}$/K from that of the silicon and has a thermal conductivity which is greater than 3 W/m K, and that the metal layer (3) is connected to the silicon semiconductor (5) by means of a layer of solder (4).

2. Electric contact according to Claim 1, characterised in that the ceramic material (1) has a thickness of 50 to 3 000 µm and that the metal layer (3) has a thickness of 20 to 3 000 µm, the ratio between the thickness of the ceramic material (1) and the thickness of the metal layer (3) being greater than 1.

3. Electric contact according to Claim 2, characterised in that the metal layer (3) has a maximum yield stress of 50 MPa for 0.2 % deformation and a maximum specific resistance of $20 \cdot 10^{-9}$ Ω.m.

4. Electric contact according to Claim 3, characterised in that the metal layer (3) consists of copper.

5. Electric contact according to one of Claims 1 to 4, characterised in that the ceramic material (1) is mullite, which has the chemical name $3Al_2O_3 \cdot 2SiO2$.

6. Electric contact according to one of Claims 1 to 4, characterised in that the ceramic material (1) is tin oxide.

7. Electric contact according to one of Claims 1 to 6, characterised in that the ceramic material (1) has a thickness of 500 µm and the metal layer (3) has a thickness of 300 µm.

8. Electric contact according to one of Claims 1 to 7, characterised in that an aluminium layer (4) is provided for joining the material of the metal layer (3) to that of the silicon semiconductor (5).

**Revendications**

1. Contact électrique pour un semi-conducteur en silicium (5), qui est formé d'une structure faite d'une céramique (1) et d'une couche métallique (3), la couche métallique (3) présentant une faible résistance électrique et étant unie d'un côté par un mélange eutectique (2) à la céramique (1) et de l'autre côté de manière cohésive au semi-conducteur en silicium (5), caractérisé en ce que la structure (1) possède un coefficient de dilatation thermique linéaire qui s'écarte de la valeur de celui du silicium au maximum de $3 \cdot 10^{-6}$/K et une conductibilité thermique qui est supérieure à 3 W/m K, et la couche métallique (3) est reliée au semi-conducteur en silicium (5) par une couche de brassure (4).

2. Contact électrique suivant la revendication 1, caractérisé en ce que la céramique (1) a une épaisseur de 50 à 3 000 µm et la couche métallique (3) une épaisseur de 20 à 3 000 µm, le rapport entre l'épaisseur de la céramique (1) et celle de la couche métallique (3) étant supérieur à 1.

3. Contact électrique suivant la revendication 2, caractérisé en ce que la couche métallique (3) a une tension de fluage maximum de 50 MPa pour une déformation de 0,2 % et une résistance spécifique maximum de $20 \cdot 10^{-9}$ Ω.m.

4. Contact électrique suivant la revendication 3, caractérisé en ce que la couche métallique (3) est en cuivre.

5. Contact électrique suivant l'une quelconque des revendications 1 à 4, caractérisé en ce que la céramique (1) est de la mullite qui répond à la formule chimique $3Al_2O_3 \cdot 2SiO_2$.

6. Contact électrique suivant l'une quelconque des revendications 1 à 4, caractérisé en ce que la céramique (1) est de l'oxyde d'étain.

7. Contact électrique suivant l'une quelconque des revendications 1 à 6, caractérisé en ce que la céramique (1) a une épaisseur de 500 µm et la couche métallique (3) une épaisseur de 300 µm.

8. Contact électrique suivant l'une quelconque des revendications 1 à 7, caractérisé en ce qu'une couche d'aluminium (4) est prévue pour unir de manière cohésive la couche métallique (3) au semi-conducteur en silicium (5).

Fig. 1

Fig. 2